Europäisches Patentamt

European Patent Office

Office européen des brevets

(11) Publication number: **0 398 612**
**A1**

## (12) EUROPEAN PATENT APPLICATION

(21) Application number: **90305167.0**

(22) Date of filing: **14.05.90**

(51) Int. Cl.⁵: **C04B 35/00, C04B 35/64,**
**F27D 5/00, H01L 39/24**

(30) Priority: **15.05.89 JP 120688/89**

(43) Date of publication of application:
**22.11.90 Bulletin 90/47**

(84) Designated Contracting States:
**BE DE FR GB SE**

(71) Applicant: **NGK INSULATORS, LTD.**
**2-56, Suda-cho, Mizuho-ku**
**Nagoya City Aichi Pref.(JP)**

(72) Inventor: **Shimizu, Hideki, NGK Ichioka-ryou,**
**38-2**
**Ichioka-cho 2-chome, Mizuho-ku**
**Nagoya City, Aichi prefecture 467(JP)**
Inventor: **Yoshida, Manabu**
**31 Aza-tomoura, Meichi**
**Bisai-city, Aichi Prefecture(JP)**
Inventor: **Watanabe, Keiichiro, 4E,**
**Cooperative**
**Nakanomachi House, 22-31 Sakae 1-chome**
**Naka-ku, Nagoya City, Aichi prefecture(JP)**

(74) Representative: **Paget, Hugh Charles Edward**
**et al**
**MEWBURN ELLIS 2 Cursitor Street**
**London EC4A 1BQ(GB)**

(54) **Sintering method for preparation of planar oxide superconductor.**

(57) A sintering method for preparation of a planar oxide superconductor comprising sintering under a gaseous atmosphere containing oxygen a green shaped plate while uniformly contacting entire surface of the shaped plate with the gaseous atmosphere, wherein the green shaped plate is made of a ceramic superconducting powder and/or a precursor powder which shows superconducting properties following heat treatment. A heat treatment method for perparation of a planar oxide superconductor comprising heat treating under a gaseous atmosphere containing oxygen a primary sintered or calcined shaped plate while uniformly contacting the entire surface of the plate with the gaseous atmosphere, wherein the primary sintered or calcined shaped plate is obtained by sintering or calcining a green shaped plate made of a ceramic superconducting powder and/or a precursor powder which becomes superconductive by heat treatment.

# SINTERING METHOD FOR PREPARATION OF PLANAR OXIDE SUPERCONDUCTOR

The present invention relates to a sintering method for preparation of planar oxide superconductors, and also to a heat-treatment method for preparation of the same.

In recent years, high critical temperature oxide superconductors have drawn attention because of their possible applications in such fields as electrical power, MRI (magnetic resonance imaging), magnetic shields, etc.

Planar oxide superconductors have generally been prepared by the steps of shaping, such as press shaping, slip casting and isostatic pressing, and sintering under a gaseous atmosphere containing oxygen to cause crystallization which provides superconducting properties. The firing and sintering of the shaped green body are carried out by setting it on a setter which is a flat board made of alumina and resistant to high temperature in the same manner as that for conventional ceramic products.

However, when a green shaped plate (green body) composed of ceramic superconducting powder and/or precursor powder which shows superconducting properties by heat treatment is sintered in the same bay as conventional ceramic products, the sintered product is liable to have an uneven, or non-uniform, crystal phase and chemical composition.

As a result, it is very difficult to obtain a planar oxide superconductor having a completely uniform composition.

The present inventors have studied possible methods of making the composition of a whole shaped plate of an oxide superconductor uniform, and also of causes of the non-uniform composition in a sintered shaped plate resulting from the conventional sintering of a green shaped plate composed of a ceramic superconducting powder and/or a precursor powder which shows superconducting properties by heat treatment. As a result, it has been found that the non-uniform composition appears frequently at surfaces of plate superconductors which contact the planar setter during firing, and the present invention has been completed to prevent such non-uniform compositions from occurring.

It is an object of the present invention to provide a sintered shaped plate of an oxide superconductor having a completely uniform composition by the sintering of a green shaped plate which comprises a ceramic superconducting powder and/or a precursor powder which shows superconducting properties by heat treatment.

According to the present invention, there is provided a sintering method for the preparation of a planar oxide superconductor which comprises sintering under a gaseous atmosphere containing oxygen a green shaped plate whose entire surface uniformly contacts the gaseous atmosphere, where said green shaped plate is made of a ceramic superconducting powder and/or a precursor powder which has superconducting properties when it is heat treated.

According to the present invention, there is further provided a heat treatment method for the preparation of a planar oxide superconductor which comprises heat-treating under a gaseous atmosphere containing oxygen a primary sintered shaped plate or calcined shaped plate, essentially the entire surface of which uniformly contacts the gaseous atmosphere, said primary sintered shaped plate or calcined shaped plate being obtained by sintering or calcining a green shaped plate made of a ceramic superconducting powder and/or a precursor powder which has superconducting properties when it is heat treated.

In the accompanying drawings:

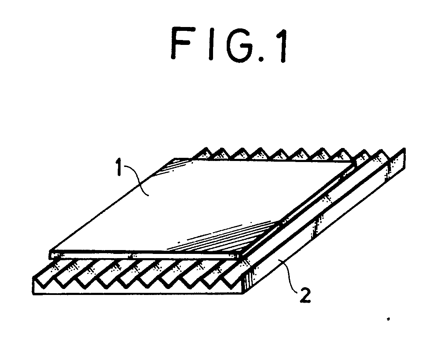

Fig. 1 is a schematic illustration of one embodiment of a shaped plate placed on a setter for the sintering procedure of the present invention.

The present invention is explained hereunder in more detail.

As the oxide superconducting materials useful in the present invention, there are used, for example, compounds of a M-Ba-Cu-O system ( M is at least one element selected from Sc, Tℓ, Y and Lanthanoid elements including La, Eu, Gd, Er, Yb, Lu, etc.) and compounds of a Bi-Sr-Ca-Cu-O system having multi-layered Perovskite structures.

In the present invention, the kinds of ceramic superconducting powders are not particularly restricted. There can be used, for example, those having crystal phases of a $Bi_2Sr_2CaCu_2O_8$ composition for a Bi-Sr-Ca-Cu-O system and of $YBa_2Cu_3O_{7-y}$ for a YBaCuO system.

As for precursory powders which show superconducting properties by heat treatment, there are employed, for example, mixed powder of oxides, carbonates, hydroxides, alkoxides, nitrates, etc. of each metal component of the desired planar oxide superconductor, intermediate products obtained by calcining the above mixed powder at lower temperatures than those which produce superconducting properties, and/or frit powders obtained by melting of the above mixed powder at high temperatures, quenching and grinding.

As for raw material powders to be shaped into plates, there can be also employed mixtures of the above-mentioned ceramic superconducting powders and precursor powders which show superconducting properties by heat treatment.

As a raw material for the planar (plate) oxide superconductors in the present invention, there can be used not only the above-mentioned various powders but also granules of the powders, if preferred.

When the above-mentioned raw material powders (the term "powders" hereinafter includes granules) are employed for shaped products, organic binders are generally added to the powders. As for the organic binder, polyvinylalcohol, polyvinylbutyral, etc., for example, can be employed.

For the method of forming the shaped plate in the present invention, there can be used, for example, such conventional methods as metal mold pressing, slip casting, isostatic pressing, extrusion forming, injection molding, etc. In the present invention, the shaped plate has a prescribed thickness, however, the dimensions and shape are not restricted, for example, circular, polygonal, irregular shapes or non-flat surface are allowed.

Thus a planar oxide superconductor obtained by sintering or heat-treating the shaped plate is generally flat and has a prescribed thickness although the dimensions and shape are not restricted and include circular, polygonal, irregular shapes.

The shaping can be effected with powdery, granulated or melted raw material, or a slurry of raw material powder in water or organic solvents. As the organic solvents for preparing the slurry, toluene, ethanol, ethylacetate, butanol, etc., for example, can be employed, and plasticizer can be added to the solvents, if needed.

When an organic binder and/or an organic solvent is used for the shaping, the shaped article is preferably pre-treated at 500-930°C under an atmosphere containing oxygen to reduce the residual carbon content to lower than 0.5% by weight, prior to sintering at above 900°C.

In the present invention, the sintering of the green shaped plate obtained as mentioned above is effected by contacting essentially the entire surface of the plate uniformly with an atmospheric gas containing oxygen in a furnace.

One means of contacting the surface of the plate uniformly with the oxygen-containing gas in the furnace is to use as a setter, or support, on which the shaped plate is to be placed, for example, a porous board, a porous board having a rugged surface and a solid (non-porous) board having a rugged surface and flowing the oxygen-containing gas toward the bottom surface of said shaped plate through the pores or voids made between the shaped plate and the setter.

According to the above method, the bottom surface of the shaped plate placed on the setter can come in contact with the oxygen-containing gas supplied through the setter.

When a shaped plate is placed on a conventional flat-shaped setter made of alumina, etc., the bottom surface of the shaped plate is so intimately contacted with the flat shaped setter that it is impossible for the atmospheric gas in the furnace to contact uniformly and sufficiently the bottom surface of the shaped plate in the same degree as the other surfaces of the shaped plate. In contrast to the above, according to the present invention, since the shaped plate is placed on a setter made of, for example, a porous board, a porous board having a rugged surface or a solid (non-porous) board having a rugged surface, pores or voids are formed between the bottom of the shaped plate and the setter resulting in a reduction of the area of contact between the bottom of shaped plate and the setter. As used herein the terminology 'rugged surface' means a surface having one or more convex or concave portions which provide a passage for the flow of the oxygen-containing gas. Thus the oxygen-containing gas can flow sufficiently to the bottom portion of the shaped plate, and can contact uniformly and sufficiently the bottom portion of the shaped plate.

As for the setter used in the present invention, the contact area between it and the shaped plate is smaller than the area of the shaped plate when projected onto the setter.

The contact area between the shaped plate and the setter is preferably not more than 80% of said projected area. Further, in the setter, a contacting portion for supporting the shaped plate can be plural dots or small circles, lines, bands, planes or combination thereof, and when the contacting portion is dots, or points, each of them has an area of preferably not larger than 10 $cm^2$ and when it is lines or planes, each of them has a width of preferably less than 8 mm. The pitch between contacting portions should be such that the non contact area occupies preferably more than 25% of the total contact area between the setter and the shaped plate.

As examples of the setter, there may be mentioned a porous board, a rugged board such as an angle-type board and a board having grooves, a board having penetrating portions such as holes, etc. As the porous board, there can be used known materials having pores such as, for example, honeycomb-structure ceramics used as catalyst carriers for automobile exhaust gas treatment. The surface of the porous board may be planar or rugged with grooves. Such rugged-boards as angle-type boards, boards having grooves and boards having holes need at least to retain the convex portions like the angle-type, the concave portions like the grooves or the penetrating portions on the contact side surface with the shaped plate. The form of the convex, concave, or penetrating portions is not limited. Therefore, the board may also be made from a combination of bars having polygonal or circular crosssectional shapes, for exemple, by arranging more than two bars in parallel, in a lattice or randomly in a flat or piled-up form so as to form convex-concave or penetrating portions.

As the setter, there may also be employed appropriately arranged plural pieces of the above mentioned arbitrary shaped porous plates or boards, or circular or polygonal shaped pieces having a specified thickness. Further, appropriately placed particles of inorganic materials having an average diameter of 500 $\mu$m or more may be employed to place the shaped plate thereon.

In the present invention, one or more kinds of setter mentioned above may be arranged in one stage or in multi-stages. When porous boards such as honeycomb-structure boards are arranged in a multi-stage, it is preferable to arrange them, for example, such that the honeycomb holes of the honeycomb structures are offset from each other.

As materials suitable for the setter in the present invention, there are inorganic oxides such as alumina, partially stabilized zirconia (PSZ), stabilized zirconia, titania, silica, mullite, cordierite and carbides, nitrides, etc. such as silicon carbide and silicon nitride.

In the present invention, when the shaped plate is placed on a setter, it is preferable that the shaped plate is supported on the setter on the side which has the maximum projected area on the setter, and further which is parallel to the plane of the contact portions between the shaped plate and the setter.

In the present invention, sintering is conducted under an atmosphere of an oxygen-containing gas in a manner such that the gas can contact the bottom portion of the shaped plate placed on the setter through the above mentioned voids formed between the setter and the shaped plate. During sintering in a furnace, the furnace is filled with the oxygen-containing gas atmosphere. In this case the furnace can be maintained either in a closed condition without flowing of the gas or under flowing of the oxygen-containing gas through a gas inlet and a gas outlet. Providing a flow of the oxygen-containing gas is preferred, and supply of the oxygen-containing gas is appropriately conducted according to inner size of the furnace and the sintering schedule, etc. Usually, the supply is 0.1 $\ell$/min. or more, and the gas inlet and outlet are preferably provided in the furnace so that the shaped plate placed on the setter is maintained within the flow path of the oxygen-containing gas to attain efficient contact with the gas.

Sintering temperature in the method of the present invention can be selected appropriately in accordance with the particular raw material powder and kinds of superconductors, and is usually 880 $^\circ$C or more.

In the present invention, as a calcined or primary sintered shaped plate composed of a ceramic superconducting powder and/or a precursor powder which shows superconducting properties when heat treated there can be used a calcined plate obtained by heat treating at 500-900 $^\circ$C a shaped plate composed of a ceramic superconducting powder and/or a powder which shows superconducting properties following heat treatment, or a primary sintered plate having insufficient superconducting properties obtained by sintering on a conventional alumina setter. According to the present invention, the calcined plate or the primary sintered plate acquires superconducting properties or its superconducting properties are improved.

Heat treatment of the calcined or primary sintered plate is conducted in the same way as the above-mentioned sintering method for the shaped plate. The calcined or primary sintered plate is placed on the above-mentioned setter and is uniformly contacted on all of its surfaces with the oxygen-containing gas during heat treatment, by which the calcined or primary sintered plate acquires superconducting properties or has its superconducting properties improved.

For the heat treatment of the calcined plate, treatment at 900 $^\circ$C or more is preferred, and for the primary sintered plate, treatment at 300-950 $^\circ$C is preferred, for a specified period of time.

According to the present invention, a shaped plate composed of a ceramic superconducting powder having superconducting properties and/or a powder which acquires superconducting properties by heat treatment, and a calcined plate or a primary sintered plate can be sintered to produce a shaped plate of an oxide superconductor having a uniform composition through uniform contact with an oxygen-containing gas on all of the surfaces of the shaped plate. To provide uniform contact between the shaped plate and the oxygen-containing gas, especially to provide sufficient contact with the oxygen-containing gas at the bottom portion of the plate, voids are provided between the shaped plate and the setter on which the plate is placed, to allow the oxygen-containing gas to reach the bottom surfaces of the shaped plate.

## EXAMPLES

The present invention is explained in more detail by reference to the following examples. However, it is to be noted that the description is illustrative and the invention is not intended to be limited to the preferred embodiments.

## Example 1

In a molar ratio of 1/2 : 2 : 3, $Y_2O_3$, $BaCO_3$ and CuO were mixed in a rotary mill to produce a powder and then dried in a spray-dryer. The resultant powder mixture was calcined at 920°C for 10 hours, and the calcined bulk was ground and mixed with toluene as an organic solvent and granulated by using a spray-dryer. The resultant granule was processed by a press shaping method to a square shaped plate with a dimension of 360 x 360 x 8 mm.

An alumina board was placed in a furnace, and many honeycomb-structure cordierite circular plates having a 100 mm diameter and a 10 mm thickness were randomly placed with the honeycomb holes oriented vertically on the alumina board. On the first stage of plates formed as above, the same circular plates were placed intimately in a manner that the upper stage plates cover spaces of the lower stage and the upper stage honeycomb holes did not correspond with the honeycomb holes of the lower stage.

The above-shaped plate was placed on the upper stage of the circular honeycomb plates. An inlet for oxygen gas to be supplied to the sintering furnace was provided at the side of the cordierite circular plates, and the oxygen gas was supplied to bottom portions of the shaped plate through voids among the cordierite circular plates and honeycomb holes of the upper stage and also through voids among the cordierite circular plates of the lower stage, and the inside of the furnace was filled with oxygen gas. Then, sintering was continued for 6 hours at a maximum temperature of 960°C.

As a result, a sintered plate of 305 x 305 x 5 mm having no warp nor crack was obtained. The crystal phase of each of the upper surface, lower surface and inside of the resultant sintered plate was measured using X-ray diffraction, and it was found that the upper surface, lower surface and inside were of a single phase with superconducting properties.

The sintered plate exhibited the Meissner effect in liquid nitrogen, and the cut-specimen showed a critical current density of $75A/cm^2$ when measured in liquid nitrogen by a four-probe method. The residual carbon content in the sintered plate was 0.18% by weight.

## Example 2

A shaped superconducting sintered plate was obtained in the same manner as that of Example 1 with the exception that mullite honeycomb flat boards having a square shape of 100 x 100mm and a thickness of 10 mm were employed in place of the cordierite honeycomb circular plates having a 100 mm diameter and a 10 mm thickness.

The resultant sintered plate was shown by X-ray diffraction to have a single phase having superconducting properties at the upper surface, lower surface and inside. Further, the sintered plate exhibited the Meissner effect in liquid nitrogen.

In the same manner as in Example 1, the cut-specimen showed a critical current density of $83A/cm^2$ when measured in liquid nitrogen. The residual carbon content in the sintered plate was 0.17% by weight.

## Example 3

Fig. 1 is an illustrative drawing showing an example of a shaped plate placed on a setter for sintering according to the present invention. In Fig 1, a shaped plate 1 identical with that prepared in Example 1 was placed on a PSZ angle-type board 2 in the shape of a square of 400 x 400 mm and a thickness of 10 mm and was sintered in the same manner as in Example 1 to obtain a shaped superconducting sintered plate.

The sintered plate was shown by X-ray diffraction to have a single phase at the upper surface, lower surface and inside having superconducting properties. The sintered plate exhibited the Meissner effect in liquid nitrogen.

In the same way as in Example 1, the cut-specimen showed a critical current density of $71A/cm^2$ when measured in liquid nitrogen. The residual carbon content in the sintered product was 0.18% by weight.

## Example 4

A plate identical with that prepared in Example 1 was placed on an alumina flat board in the shape of a square of 400 x 400 mm and a thickness of 10 mm, and oxygen was supplied from the side of the plate, similar to conventional sintering. The resultant primary sintered plate had an uneven phase at the bottom surface.

The primary sintered plate obtained above was placed on the upper stage of cordierite circular plates as in Example 1, and then was heat-treated for 5 hours at a maximum temperature of 930°C. Oxygen was supplied during the heat-treating from the side of the sintered plate, similar to conventional sintering.

The resulted heat-treated plate was shown by X-ray diffraction to have a single phase at the upper surface, lower surface and inside having superconducting properties. The heat-treated plate exhibited the Meissner effect in liquid nitrogen.

In the same way as in Example 1, the cut-specimen showed a critical current density of 65A/cm$^2$ when measured in liquid nitrogen. The residual carbon content in the heat-treated plate was 0.19% by weight.

## Example 5

A plate identical with that prepared in Example 1 was set on an alumina flat board in the shape of a square of 400 mm x 400 mm and a thickness of 10 mm, and was calcined to degrease it for 20 hours at a maximum temperature of 880°C.

Oxygen was supplied from the side of the plate, similar to conventional sintering.

The resulted calcined plate was placed on the upper stage of cordierite circular plates as in Example 1, and was heat-treated further for 6 hours, at a maximum temperature of 960°C. Oxygen was supplied during the sintering from the side of the calcined plate, similar to conventional sintering.

The resulted heat-treated plate was shown by X-ray diffraction to have a single phase at the upper surface, lower surface and inside having superconducting properties. The heat-treated body exhibited the Meissner effect in liquid nitrogen. In the same way as Example 1, the cut-specimen showed a critical current density of 85A/cm$^2$ when measured in liquid nitrogen. The residual carbon content in the heat-treated plate was 0.14% by weight.

## Comparative Example 1

A plate identical with that prepared in Example 1 was set on an alumina flat board in the shape of a square of 400 mm x 400 mm and a thickness of 10 mm, and was sintered using the same procedure as in Example 1, but oxygen was supplied from the side of the plate in a manner similar to conventional sintering. The resulted sintered plate had cracks and X-ray diffraction showed a single superconducting phase at the upper surface. However, the lower surface showed two phases of a superconducting phase and a oxygen-lacking phase. The sintered plate exhibited a weak Meissner effect in liquid nitrogen.

In the same way as in Example 1, the cut-specimen was measured in liquid nitrogen and showed a critical current density of 0 A/cm$^2$. The residual carbon content was 0.96% by weight.

## Claims

1. A sintering method for preparation of a planar oxide superconductor having a uniform cystal phase throughout, which comprises: sintering under a gaseous atmosphere containing oxygen a green shaped plate while contacting all of the surfaces of the green shaped plate with the gaseous atmosphere, said green shaped plate comprising a ceramic superconducting powder or a precursor powder which shows superconducting properties when heat treated.

2. A sintering method for preparation of a planar oxide superconductor according to Claim 1, wherein said green shaped plate is placed on a setter through which an oxygen-containing gas is supplied to uniformly contact the bottom surface of said green shaped plate during sintering.

3. A sintering method for preparation of a planar oxide superconductor according to Claim 2, wherein said setter is made of a porous material and/or a solid material having a rugged surface.

4. A heat treatment method for preparation of a planar oxide superconductor having a uniform crystal phase throughout, which comprises: heat treating under a gaseous atmosphere containing oxygen a primary sintered or calcined shaped plate while contacting all of the surfaces of the shaped plate with the gaseous atmosphere, said primary sintered or calcined shaped plate being obtained by sintering or calcining a green shaped plate made of a ceramic superconducting powder and/or a precursor powder which shows superconducting properties when heat treated.

5. A heat treatment method for preparation of a planar oxide superconductor according to Claim 4, wherein said primary sintered or calcined shaped plate is placed on a setter through which an oxygen-containing gas is supplied to uniformly contact the bottom surface of said primary sintered or calcined shaped plate during heat treating.

6. A heat treatment method for preparation of a planar oxide superconductor according to Claim 5, wherein said setter is made of a porous material and/or a solid material having a rugged surface.

7. In a method of preparing a planar oxide superconductor wherein a green shaped body supported on a setter is sintered in an oxygen-containing atmosphere, the improvement wherein the setter is porous and/or has an uneven surface which reduces the area of contact between the green shaped body and the setter and allows the oxygen-containing gaseous atmosphere to uniformly contact all surfaces of the green shaped body.

# F I G.1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | GB-A- 689 228 (ERIE RESISTOR CORP.) * Claims 1-4; figures 1-3 * | 1-7 | C 04 B 35/00 C 04 B 35/64 F 27 D 5/00 H 01 L 39/24 |
| Y | GB-A- 231 939 (EONIT LTD) * Claims 1-6; page 1, lines 69-76 * | 1-7 | |
| Y | EP-A-0 002 193 (N. STEULER) * Page 1, line 9 - page 2, line 12; page 3, lines 1-7 * | 1-7 | |
| Y | US-A-3 314 666 (V.H. GAJARDO) * Column 4, lines 17-46; figure 7 * | 1-7 | |
| Y | WO-A-8 810 237 (DU PONT DE NEMOURS AND CO.) * Claims 1,2; page 10, lines 5-18 * | 1-7 | |
| A | EP-A-0 284 088 (SUMITOMO ELECTRIC IND.) * Page 5, lines 10-40 * | 1-7 | TECHNICAL FIELDS SEARCHED (Int. Cl.5) C 04 B F 27 D H 01 L |

The present search report has been drawn up for all claims

| Place of search | Date of completion of the search | Examiner |
|---|---|---|
| THE HAGUE | 20-08-1990 | LUETHE H. |